(19) Europäisches Patentamt
European Patent Office
Office européen des brevets

(11) Veröffentlichungsnummer: **0 373 220 A1**

(12) **EUROPÄISCHE PATENTANMELDUNG
veröffentlicht nach Art. 158 Abs. 3
EPÜ**

(21) Anmeldenummer: **88905470.6**

(51) Int. Cl.[5]: **C04B 35/50, H01B 12/00**

(22) Anmeldetag: **20.05.88**

(86) Internationale Anmeldenummer:
**PCT/SU88/00113**

(87) Internationale Veröffentlichungsnummer:
**WO 88/09311 (01.12.88 88/26)**

(30) Priorität: **26.05.87 SU 4244487**

(43) Veröffentlichungstag der Anmeldung:
**20.06.90 Patentblatt 90/25**

(84) Benannte Vertragsstaaten:
**AT BE CH DE FR GB IT LI LU NL SE**

(71) Anmelder: **INSTITUT STRUKTURNOI MAKROKINETIKI AKADEMII NAUK SSSR
Moskovskaya olb.
Chernogolovka, 142432(SU)**

(72) Erfinder: **MERZHANOV, Alexandr Grigorievich
ul. Tretya, 3-2 Moskovskaya obl.
pos. Chernogolovka, 142432(SU)**
Erfinder: **BOROVINSKAYA, Inna Petrovna
ul. Tretya, 3-2 Moskovskaya obl.
pos. Chernogolovka, 142432(SU)**
Erfinder: **NERSESIAN, Mikael Davidovich
Institutsky pr., 4-120 Moskovskaya obl.
pos. Chernogolovka, 142432(SU)**
Erfinder: **PERESADA, Andrei Gennadievich
ul. Tsentralnaya, 4v-56 Moskovskaya obl.
pos. Chernogolovka, 142432(SU)**

(74) Vertreter: **von Füner, Alexander, Dr. et al
Patentanwälte v. Füner, Ebbinghaus, Finck
Mariahilfplatz 2 & 3
D-8000 München 90(DE)**

(54) **SUPRALEITENDES OXYDMATERIAL UND VERFAHREN ZUR HERSTELLUNG.**

(57) The method relates to obtaining superconducting materials, in particular, compounds of formula (I) where Y = 6-8, Ln is Y, -Sc or a lanthanoid; $M^{II}$ is Ba, Ca, Sr: $M^{I}$ is Cu; Cu + Ag, or of formula (II) where x = 1-2 and consists in a local initiation of an exothermic reaction in a mixture of initial components chosen so as to obtain the above-mentioned compounds. The exothermic mixture of components consists of an incombustible component and an igniting component, the latter comprising: at least one metal chosen from the group: a rare-earth metal of the periodic system from the following: scandium, yttrium, lanthanoids, a metal of the second group of the periodic system, a metal of the first group of the periodic system and/or a hydride of at least one of the metals mentioned.

EP 0 373 220 A1

# SUPRALEITENDER OXIDISCHER WERKSTOFF UND VERFAHREN ZUR HERSTELLUNG DESSELBEN

## Gebiet der Technik

Die vorliegende Erfindung bezieht sich auf supraleitende oxidische Werkstoffe, die ein Seltenerdmetall, ein Metall der ersten und der zweiten Gruppe des Periodensystems aufweisen, und betrifft sie Verfahren zur Herstellung derselben.

Die Hauptkriterien der Qualität supraleitender Werkstoffe sind folgende: Temperatur des Beginns ($T_{Beg.}$); $T_{(Mit.)}$ und Temperatur des Endes des Ubergangs ($T_{End.}$); zum supraleitenden Zustand, Bandbreite des Ubergangs zum supraleitenden Zustand ( $\Delta T$), Dichte des rkritischen Stromes und Zeitkonstanz der genannten Eigenschaften.

## Zugrundeliegender Stand der Technik

Gegenwärtig bekannte supraleitende oxidische Werkstoffe folgender Zusammensetzung $LnBa_2$, $Cu_3O_{6,5-7}$, worin Ln - Sc, Y oder ein Metall der Gruppe der Lanthanoide ist, haben $T_{Beg.}$ von 40 bis 95 K, $T_{End.}$ von 26 bis 75 K mit einem breiten Band (bis 50 K) des Ubergangs zum supraleitenden Zustand. Solche Werkstoffe weisen in der Regel eine niedrige Qualität auf und enthalten neben der supraleitenden Phase auch Beimengungen von Ausgangskomponenten, was die Wertstreuung $T_{Beg.}$ und $T_{End.}$ $\Delta T$ beeinflusst, sie haben zeitunbeständige Kenndaten (supraleitende Kenndaten verringern sich im Ergebnis der Lagerung des Werkstoffs an der Luft), sie halten geringe kritische Stromstärke aus.

Supraleitende oxidische Werkstoff stellen zusammengepresste Probekörper schwarzer Farbe mit Abmessungen der Teilchen von I bis 30 $\mu m$ und unterschiedlicher Dichte des Fertigwerkstoffes dar.

Zur Herstellung der genannten supraleitenden Werkstoffe kommt gegenwärtig die Wärmebehandlung der Ausgangsoxide von La, Ba und Cu in Frage. Ublicherweise werden die Pulver der $La_2O_3$-, BaO und CuO-Oxide nach einer sorgfältigen Vermischung mittels Pressung geformt, in einem Elektroofen untergebracht und bei einer Temperatur von 900 bis II00°C dem Sinterbrennen während einer längeren Zeit ausgesetzt.

Bekannte Verfahren zur Herstellung von supraleitenden Werkstoffen zeichnen sich durch einen hohen Stromverbrauch, durch eine grosse Dauer des Prozesses, seine Mehrstufigkeit, eine niedrige Leistung und eine geringe Ausbeute an supraleitender Phase aus.

Bekannt ist, beispielsweise, ein supraleitendes Seltenerdmetall (Yttrium), ein Metall der ersten Gruppe (Kupfer), ein Metall der zweiten Gruppe (Barium) folgender Zusammensetzung ($Y_{0,9}Ba_{0,I}$) $CuO_y$ mit $T_{Beg.}$ = 95 K, $T_{End.}$ = 75 K, $\Delta T$ = 20 K. Für die Herstellung des genannten Werkstoffes werden die Ausgangspulver aus $Y_2O_3$, $BaCO_3$ und CuO bei einem entsprechenden Verhältnis der Wärmebehandlung zunächst bei einer Temperatur von I000°C und dann bei II00°C während mehrerer Stunden ausgesetzt.

(Hidenori Takagi, Shin-Ichi Uchida Kohji Kishio, Koichi Kitazawa, Kazuo Feuki and Shoji Tanaka "High-Tc Superconductivity and Diamagnetism of Y-Ba-Cu-Oxides", Japanese Journal of Appl. Phys. vol. 26, No. 4, April, I987, pp. L320-L32I).

Der gemäss dem beschriebenen Verfahren hergestellte Werkstoff weist mehrere Phasen mit ungleichmässiger Verteilung der Phasen im Volumen des jeweiligen Probekörpers und neben der supraleitenden Hauptphase auch Einschlüsse von Ausgangskomponenten $Y_2O_3$, CuO und $Cu_2O$ auf. Das Verfahren zur Herstellung des Werkstoffes weist mehrere Stufen auf, ist langwierig und hat hohe Energieaufwünde.

Ein anderer bekannter supraleitender Werkstoff allgemeiner Zusammensetzung Y-Ba-Cu-O hat $T_{Beg.}$ = 90 K und $T_{End.}$ = 77K. Das Verfahren zur Herstellung eines derartigen Werkstoffes sieht die Zubereitung eines Beschickungsgutes aus $Y_2O_3$, $BaCO_3$ und CuO, die in einem bestimmten Gewichtsverhältnis genommen werden, die Formung des Beschickungsgutes mittels Pressung zu einem Probekörper Wärmebehandlung des Beschickungsgutes bei einer Temperatur 900°C während 6 Stunden in verdünntem Sauerstoff-Medium (P = 2 x $I0^{-5}$ Bar), die Zerkleinerung des Probekörpers, die wiederholte Pressung aus demselben einer Tablette und anschliessende Wärmebehandlung bei einer Temperatur von 925°C während 24 Stunden vor.

Der hergestellte Werkstoff weist keine hohe Qualität, ist in seiner Phasen-Zusammensetzung inhomogen mit Beimengungen von Kohlenstoff bis 0,I Masse%. Das Verfahren zur Herstellung des supraleitenden Werkstoffes ist mehrstufig, langwierig (bis IO Stunden) und hat hohe Energieaufwände.

(M.K.Wu, J.R.Achburn and C.J.Torng "Superconductivity at 93 K in a New Mixed-Phase Y-Ba-Cu-O Compound System at Ambient Pressure", Phys. Rev. Letters vol. 58, No. 9, March I987, p. 908).

Bekannt ist ein supraleitender Werkstoff, der als Seltenerdmetalle Holmium (Ho), Barium und Kupfer aufweist, das dessen Herstellungsverfahren die Zubereitung von Beschickungsgut aus $Ho_2O_3$, CuO und $BaCO_3$ bei zwei Verhältnissen der Komponenten vorsieht, dabei das Atomverhältnis Ho : Ba : Cu wie folgt ist:

0,246 : 0,336 : I (I)

und 0,3I6 : 0,335 : I (2).

Bei jedem der Verhältnisse (I) und (2) werden die Komponenten nach dem Vermischen der Wärmebehandlung bei einer Temperatur von 850°C innerhalb von 2 Stunden an der Luft ausgesetzt, wonach man aus den Gemischen Probekörper mit Abmessungen (8 x 2 x I,5mm) formt, die man bei einer Temperatur von 800°C während I Stunde sintert (Shinobu, Hikami, Seiichi Kagoshima, Susumu Komiyama, Takashi Hirai, Hidetoshi Minami and Taizo Masumi "High Tc Magnetic Superconductor: Ho-Ba-Cu Oxide", Japanese of Appl. Phys. vol. 26, No. 4, April, I987, p.p. L347-L348).

Die gemäss dem genannten Verfahren hergestellten Werkstoffe weisen

$T_{Beg.} = 93$ K, $T_{End.} = 76$ K (I)

$T_{Beg.} = 74$ K, $T_{End.} = 47$ K (II) auf.

Eine grosse Wertstreuung $\Delta T$ (Bandbreite des supraleitenden Uberganges) ist auf die Inhomogenität der Phasenzusammensetzung und auf den niedrigen Gehalt an der supraleitenden Phase im Werkstoff zurückzuführen, und das Verfahren ist energieintensiv und langwierig.

Bekannt sind supraleitende Werkstoffe, die als Seltenerdmetalle Yb, Lu, Y oder La, als ein Metall der zweiten Gruppe Ba oder Sr und als ein Metall der ersten Gruppe Kupfer aufweisen.

Der Werkstoff hat folgende Zusammensetzung: $(Ln_{I-x}M_x)_2$, $CuO_{4-6}$, wo M - Ba, Sr ist.

Das Verfahren zur Herstellung eines derartigen supraleitenden Werkstoffes sieht die Zubereitung eines Beschickungsgutes aus $Yb_2O_3$, $Lu_2O_3$, $Y_2O_3$ oder $La_2O_3$, $BaCO_3$ oder $SrCO_3$, Kupferoxid vor, dabei wird das Beschickungsgut mit sieben unterschiedlichen Zusammensetzungen zubereitet , die Wärmebehandlung der zubereiteten Beschickungsgüter bei einer Temperatur von 900°C bis zum Anfallen eines grünen Pulvers, die Pressung des Beschickungsgutes zu Tabletten und die Bearbeitung der Tabletten bei einer Temperatur von 900°C während mehrerer Stunden bis zum vollständigen Ubergang des grünen Farbtons in den schwarzen vor (Schoichi Hosoya, Shin-Ichi Shamoto, Masashige Onoda and Masatoshi Sato "High-Tc Superconductivity in New Oxide Systems", Japanese Journal of Appl. Phys. vol. 26, No. 4, April, 1987, p.p. L325-L326).

Die hergestellten Werkstoffe weisen $T_{Beg.}$ von 65 bis 95 K und $T_{End.}$ von 26 bis 60 K in Abhängigkeit von der Ausgangszusammensetzung des Beschickungsgutes auf. Die bekannten Werkstoffe weisen eine niedrige Qualität, eine breite Zone des Übergangs zum supraleitenden Zustand auf und sind inhomogen in ihrer Phasenzusammensetzung.

Das Verfahren zur Herstellung supraleitender Werkstoffe ist energieintensiv, nicht produktiv und langwierig.

Bekannt sind supraleitende Werkstoffe, die Seltenerdmetalle (Skandium, Yttrium oder Lanthanoide), ein Metall der ersten Gruppe (Cu) und ein Metall der zweiten Gruppe (Ba oder Sr) des Periodensystems folgender Zusammensetzung $LnM_2^{II}Cu_3O_y$ haben, wo $M^{II}$ - Metall der zweiten Gruppe Barium oder Strontium ist.

Das Verfahren zur Herstellung des Werkstoffes mit genannter Zusammensetzung sieht die Zubereitung eines Beschickungsg utes aus Oxid eines Seltenerdmetalls, einer Komponente vor, die ein Metall der zweiten Gruppe ($BaCO_3$ oder $SrCO_3$), CuO enthält, die bei einem solchen Verhältnis genommen werden, damit man ein supraleitender Fertigstoff bei einem Atomverhältnis der Seltenerdmetalle: Metall der II. Gruppe: Metall der I. Gruppe, Sauerstoff = I:2:3:Y. Die Ausgangskomponenten des Beschickungsgutes werden nach dem Vermischen und Zerkleinern der Wärmebehandlung bei einer Temperatur von 950°C in einem sauerstoffhaltigen Medium innerhalb von I2 Stunden ausgesetzt, das angefallene schwarze Pulver wird erneut unter Vermischen zerkleinert und der Wärmebehandlung bei einer Temperatur von 950°C unter den gleichen Bedingungen ausgesetzt. Dann werden aus dem Pulver Probekörper bei P = I500 $kp/cm^2$ gepresst und sie werden der Wärmebehandlung bei einer Temperatur von 700 bis 900°C in einem Sauerstoffmedium während mehrerer Stunden ausgesetzt.

(E.M.Engler, V.Y.Lee, A .J.Nazzal, R.B.Beyers, G.Lim, P.M.Grant, S.S.P.Parkin, M.L.Ramirez, J.E.Vazquez and R.J.Savoy "Superconductivity above Liquid Nitrogen Temperature: Preparation and Properties of a family of Perovskite-Based Superconductors", J.Amer. Chem. Soc., I987, vol. I09, p.p. 2848-2849).

Die gemäss dem genannten Verfahren hergestellten Werkstoffe weisen eine niedrige Qualität auf, sind mit Beimengungen der Ausgangskomponenten, des Kohlenstoffs, verunreinigt, haben eine breite Ubergangszone zum supraleitenden Zustand, eine grosse Wertstreuung infolge einer niedrigen Ausbeute an supraleitender Phase.

Das Verfahren zur Herstellung ist kompliziert, mehrstufig, ist energieintensiv und langwierig.

Hierdurch zeugen die obengenannten Verfahren davon, dass es gegenwärtig keine Verfahren gibt, die die Herstellung von supraleitenden oxidischen Werkstoffen die ein Seltenerdmetall der ersten Gruppe und ein Metall der zweiten Gruppe des Periodensystems enthalten, mit stabilen Kenndaten einer hohen Qualität und eines hohen Reinheitsgrades der Ausgangskomponenten, mit einer hohen Ausbeute an supraleitender Phase (wenigstens 70% nach den Messungen der Magnetpermeabilität) und ihrer gleichmässigen Verteilung in einem Probekörper, mit einer schmalen (bis I K) Zone der Supraleitfähigkeit, mit vorgegebener Porosität (von 20 bis 50%), gewährleisten.

Die bekannten Verfahren zur Herstellung supraleitender Werkstoffe sind langwierig (bis 30 Stunden), sie weisen eine niedrige Leistung auf, sind energieintensiv, lassen sich schwer automatisieren und steuern.

In allen bekannten Verfahren stellen die Ausgangskomponenten des Beschickungsgutes, Oxide der Seltenerdmetalle, Oxide der Metalle der zweiten Gruppe des Periodensystems oder ihre Karbonate und Kupferoxid, Verbindungen mit dem höchsten Grad der Oxydation des in ihnen enthaltenen Metalls, das heisst ein Gemisch der Komponenten des Beschickungsgutes dar, sie sind nichtbrennbare Bestandteile.

Offenbarung der Erfindung

Der vorliegenden Erfindung liegt die Aufgabe zugrunde, einen supraleitenden . .oxidischen Werkstoff zu entwickeln, der sich nach seinen Eigenschaften von den bekannten supraleitenden Werkstoffen wesentlich unterscheidet.

Die Aufgabe wird dadurch gelöst, dass ein supraleitender oxidischer Werkstoff vorgeschlagen wird, der ein Seltenerdmetall des Periodensystems ein Metall der I. Gruppe des Periodensystems, ein Metall der II. Gruppe des Periodensystems vorsieht, das erfindungsgemäss aus einem exothermen Gemisch zubereitet wird, das sich aus

- einem nichtbrennbaren Bestandteil zusammensetzt; als solcher verwendet man ein Gemisch

- des Oxids, Halogenids, Nitrats, Karbonats und Oxalats eines Seltenerdmetalls des Periodensystems, das aus der Reihe Skansium, Yttrium oder Lanthanoide gewählt wird;

- des getrennt oder im Gemisch genommenen Oxids, Peroxids, Karbonats, Nitrats oder Halogenids eines Metalls der ersten Gruppe des Periodensystems;

- des getrennt oder im Gemisch genommenen Oxids, Peroxids, Karbonats, Nitrats oder Halogenids eines Metalls der zweiten Gruppe des Periodensystems und

- eines brennbaren Bestandteils, als solcher verwendet man mindestens ein Metall, das aus der Gruppe gewählt wurde:

- das genannte Seltenerdmetall des Periodensystems;
- das Metall der ersten Gruppe des Periodensystems;
- das Metall der zweiten Gruppe des Periodensystems und/oder ein Hydrid mindestens eines Metalls, das aus der Gruppe gewählt wird;
- das genannte Seltenerdmetall des Periodensystems;
- das Metall der zweiten Gruppe des Periodensystems, wonach man das exotherme Gemisch in einem Sauerstoffmedium mit Uberschuss an Oxydationsmittel unterbringt, man das lokale Anbrennen an beliebiger Stelle des Gemisches initiiert und den Uberschuss am Oxydationsmittel bis zu Ende der Reaktion unterhält, dabei wird das exotherme Gemisch der Komponenten bei folgendem Verhältnis in Masse%:

brennbarer Bestandteil - 65,5 - 39,46;
unbrennbarer Bestandteil - 60,54 - 93,45

in einem stöchiometrischen Verhältnis der Ausgangskomponenten, berechnet auf die Herstellung eines Fertigwerkstoffes mit der Zusammensetzung bei folgendem Atomverhältnis:

Seltenerdmetall: Metall der zweiten Gruppe des Periodensystems: Metall der ersten Gruppe des Periodensystems: Oxydationsmittel = I : 2 : 3 (6-8), genommen.

Durch Verwendung des beschriebenen Verfahrens erhält man einen supraleitenden oxidischen Werkstoff mit $T_{Beg.}$ = 92-I00 K, $T_{End.}$ = 92-95 K, $\Delta T$ = I-2 K, $T_{Mitte}$ = 90-94 K folgender Zusammensetzung $Ln\,M_2^{II}M_3^{I}O_y$, worin y = 6-8; Ln = Y, Sc oder Lanthanoide; $M^{II}$ = Ba, Ca, Sr; $M^{I}$ = Cu; Cu + Ag oder beliebiger Zusammensetzung $LnM_2^{II}M_3^{I}O_{y-x}F_x$, worin y - 6-8, x = I-2 ist.

So weist beispielsweise, der supraleitende oxidische Werkstoff mit der Zusammensetzung $YBa_2Cu_3O_7$ hergestellt, gemäss dem vorgeschlagenen Verfahren, $T_{Beg.}$ = I00 K, $T_{End.}$ = 94 K und $\Delta T$ : I (90-I0%) auf, der Gehalt an supraleitender Phase beträgt nach den Ergebnissen der Messung der Magnetpermeabilität I00%, der Werkstoff ist zeitbeständig, weist eine Porosität von 40% auf, er ist homogen in seinem Volumen, weist eine durchschnittliche Teilchengrösse von 5 µm auf und enthält Beimengungen in einer Menge von $I0^{-2}$ Masse%.

Man konnte nicht, dass das Gemisch von in der Formel genannten Ausgangskomponenten des exothermen Gemisches beim Brennen zur Herstellung eines supraleitenden Werkstoffes hoher Qualität führen kann, und dies keine offensichtliche Tatsache ist. Es ist notwendig, zahlreiche Experimente durchzuführen, um die Bedingungen des Brennens in den ähnlichen Gemischen klarzustellen.

Die Einführung eines brennbaren Bestandteils in einer Menge von 6,55 bis 39,46 Masse% in die Zusammensetzung der nichtbrennbaren Bestandteile ermöglicht es, ein Gemisch herzustellen, welches fähig ist, beim Initiieren zu brennen, was zur gleichzeitigen Oxydation aller Komponenten unter Bedingungen des Brennens führt, sowie eine Wärmehomogenisierung im gesamten Volumen des Ausgangsgemisches schnell zu erreichen; infolgedessen wird ein homogener supraleitender Werkstoff mit einem hohen Reinheitsgrad, mit einer hohen Ausbeute an supraleitender Phase, und ihrer gleichmässigen Verteilung im Volumen des Fertigwerkstoffes hergestellt. Die Prozessführung unter Bedingungen des Brennens gewährleistet seine Effektivität, eine grosse Leistung und eine geringe Energieintensität.

Als brennbarer Bestandteil verwendet man mindestens ein Metall, gewählt aus der Gruppe: ein Seltenerdmetall des Periodensystems aus der Reihe Skandium, Yttrium oder Lanthanoid, oder ein Metall der zweiten Gruppe des Periodensystems oder ein Metall der ersten Gruppe des Periodensystems und/oder Hydrid mindestens eines der genannten Metalle im erforderlichen stöchiometrischen Verhältnis zum nichtbrennbaren Bestandteil für die Herstellung eines exothermen Gemisches. Dabei ist als Metall der ersten Gruppe des Periodensystems vorzugsweise Kupfer und Silber zu verwenden, und noch mehr vorzuziehen ist Kupfer; als Metall der zweiten Gruppe des Periodensystems verwendet man vorzugsweise Kalzium, Strontium, Barium und noch mehr vorzuziehen ist Barium: als Hydride verwendet man ein Metallhydrid aus der Gruppe Yttrium, Skandium, Lanthanoide ein Gemisch der Hydride der genannten Metall, vorzugsweise Hydrid eines der Metalle aus der Reihe Yttrium, Skandium, Lanthanoide und bevorzugt ein Gemisch eines der Metalle der Gruppe Yttrium, Skandium, Lanthanoide mit dem Hydrid der genannten Metall oder.

Der Gehalt an brennbarem Bestandteil wird ausgehend von den Bedingungen der Prozessführung, der Natur der Ausgangskomponenten und von der qualitätiven Zusammensetzung des Fertigwerkstoffes gewählt.

Als nichtbrennbarer Bestandteil für die Herstellung des exothermen Gemisches verwendet man ein Gemisch aus:

- dem Oxid, Halogenid, Nitrat, Karbonat oder Oxalat eines Seltenerdmetalls oder einem Gemisch derselben;
- dem getrennt oder im Gemisch genommenen Oxid, Peroxid, Karbonat, Nitrat, Halogenid eines Metalls der ersten Gruppe des Periodensystems, vorzugsweise Peroxid, und Nitrat;
- dem getrennt oder im Gemisch genommen Oxid, Peroxid, Karbonat, Nitrat, Halogenid eines Metalls der zweiten Gruppe des Periodensystems, vorzugsweise Peroxid, Nitrat und Fluorid des Metalls, mehr vorzuziehen ist Nitrat und Peroxid,und noch mehr vorzuziehen ist Perioxid. Von den Halogeniden der Seltenerdmetalle verwendet man sein Fluorid, Bromid, Chlorid oder ihr Gemisch, vorzugsweise eines der Fluoride der Seltenerdmetalle oder Fluoridengemisch. Von den anderen Verbindungen, und zwar Nitraten, Karbonaten und Oxalaten der Seltenerdmetalle verwendet man vorzugsweise Nitrat eines der Seltenerdmetalle, oder im Gemisch mit einem Nitrat eines anderen Metalls.

In Abhängigkeit von der Zusammensetzung des erfindungsgemäss herzustellenden supraleitenden Werkstoffs werden die Ausgangskomponenten so gewählt, dass sie ein stöchiometrisches Gemisch der Komponenten bilden, berechnet auf die Herstellung eines Werkstoffs der Zusammensetzung bei einem Atomverhältnis Seltenerdmetall: Metall der zweiten Gruppe des Periodensystems: Metall der ersten Gruppe des Periodensystems: ein Oxydationsmittel gleich I : 2 : 2 : (6-8), welches brennfähig ist.

Das Brennen erfolgt dabei durch das lokale Anbrennen an beliebiger Stelle des exothermen Gemisches in einer Atmosphäre mit Uberschuss an sauerstoffhaltigem Medium aus dem Sauerstoff beziehungsweise aus einem Gemisch des Sauerstoffs mit einer Zugabe von Fluor, Argon, Stickstoff oder Luft in einer Mengen von 5 bis 80 Vol.% beim atmosphärischen Druck oder bei einem Druck von 2 bis 150 Bar (von 0,2 bis 15 MPa).

Eine besonders vorzuziehende Variante für die Lösung dieser Aufgabe ist die Prozessführung beim atmosphärischen Druck. In diesem Fall wird der Sauerstoff und/oder ein anderes Oxydationsmittel mittels Filtration durch die Komponenten des exothermen Gemischen auf Kosten eines Druckgefälles zwischen dem umgebenden Volumen und der Reaktionszone in die Reaktionszone eintreten.

Das sauerstoffhaltiges Gas kann man der Brennzone nicht nur mit Hilfe des Uberdrucke, sondern auch mittels Durchblasens dieses Gases durch das Gemisch im einem kontinuierlichen Reaktor zuführen.

Eine besonders einfache Variante für die Durchführung der vorliegenden Erfindung ist die Durchführung des Brennnens des exothermen Gemisches beim atmosphärischen Druck im Strom eines sauerstoffhaltigen Gases.

Das Anbrennen kann sowohl von der Oberfläche als auch von Innen sowie an zwei oder mehreren Stellen gleichzeitig erfolgen, wobei man das Anbrennen mit gleichem Erfolg mit einer elektrischen Spirale, mit einem elektrischen Funken, mit einem elektrischen Lichtbogen, oder mit einem Laserstrahl, vorzugsweise mit der elektrischen Spirale, vorhehmen kann. Mit dem Ziel der Regulierung der Porosität und Herstellung von Erzeugnissen vorgegebeneer Form kann das exotherme Ausgangsgemisch der Komponenten vorher zu einem erforderlichen Erzeugnis (ein Rohr, eine Platte, ein Ring, ein Zylinder) mittels Uberpressung geformt.

Zur Verbesserung der Filtrationsbedingungen des Oxydationsmittels in der Reaktionszone (Brennzone) wird dabei ein Oxydationsmedium bei seinem Druck von 2 bis 150 Bar (von 0,2 bis 15 MPa) geschaffen, welches Sauerstoff oder sein Gemisch mit einer Zugabe mindestens von Fluor, Argon, Stickstoff oder Luft in einer Menge von 5,0 bis 80 Vol.% aufweist.

Die Verwendung des Gemisches von sauerstoffhaltigem Gas unter Druck ermöglicht es, den Verbrauch am Oxydationsgas zu verringern, die Verdünnung des Sauerstoffs mit Luft gibt ausserdem die Möglichkeit, die Temperatur des Brennens des exothermen Gemisches zu regulieren, und zwar diese, beispielsweise, bei der Gewinnung der Verbindung $YBa_2Cu_3O_7$ herabzusetzen, in der als brennbarer Bestandteil $YH_2$ verwendet wird, das eine grosse Energie entwickelt.

Die Verwendung eines Gemisches aus Sauerstoff mit Fluor gilt für die Herstellung eines Werkstoffes, beispielsweise folgender Zusammensetzung $YBa_2Cu_3O_{y-2}F_2$. Das in der Zusammensetzung des supraleitenden Werkstoffes enthaltene Fluor erhöht die Qualität des herzustellenden Stoffes.

In jenen Fällen, wenn die Energie des exothermen Gemisches nicht gross ist, ist beispielsweise bei der Verwendung der Komponenten Y : Sc : BaO : CuO = 7,26 : 3,67 : : 50,09 : 38,98 ein Arbeitsgang der Vorerhitzung des Ausgangsgemisches auf 2300°C notwendig.

Die Ausgangskomponenten werden in der Regel vor dem Anbrennen bis auf einen Dispersitätsgrad von 0,0I bis 0,I mm zerkleinert und sorgfältig vermischt. Ein solcher Arbeitsgang ist für die Herstellung eines qualitätsgerechten Endproduktes und für die Prozessführung unter den stationären Bedingungen wünschenswert, obwohl auch andere Varianten des Dispersionsgrades der Komponenten des Beschickungsgutes nicht ausgeschlossen sind.

Beste Ausführungsvariante der Erfindung

Supraleitender Werkstoff $YBaCu_3O$ 6,5-7,0.

Das erfindungsgemässe Verfahren zur Herstellung dieses Werkstoffs wird wie folgt durchgeführt.

Man bereitet ein exothermes Gemisch bei einem stöchiometrischen Verhältnis der Komponenten, berechnet auf $YBa_2Cu_3O_{6,5-7}$, zu, die einen unbrennbaren Bestandteil, als solcher verwendet man $BaO_2$ und CuO, und einen brennbaren Bestandteil, Yttriumhydrid, bei folgendem Verhältnis der Komponenten in Masse% aufweisen:

$YH_2$ : $BaO_2$ : CuO = I3,6I : 50,68 : 35,7I.

Das zubereitete Gemisch der Komponenten zerkleinert man unter Vermischen in einer Kugelmühle bis auf eine Dispersität der Teilchen unter 0,I mm, vorzugsweise bis 0,02 mm. Das hergestellte Pulver wird in einem Quarz-Reaktor untergebracht, den Reaktor mit dem Inhalt bläst man mit einem Sauerstoffgemisch mit 20 Vol.% Luft durch, stellt man einen ständigen Strom des sauerstoffhaltigen Gases her und man initiiert in diesem Strom das Brennen im Komponentengemisch mittels einer der möglichen Varianten: mit einer elektrischen Spirale, mit einem Lichtbogen, mit einem Funken oder mit einem Laserstrahl an beliebiger Stelle des Gemisches. Die Umsetzung der Komponenten des Gemisches kommt auf Kosten der Wärme zustande, die sich infolge der Reaktion entwickelt und sich im Probekörper innerhalb von IO bis I5 Sekunden mit einer Geschwindigkeit von 0,I bis 0,I5 cm/s verbreitet. Die Abkühlung des angefallenen Materials auf Raumtemperatur erfolgt in einem Sauerstoffsfrom, wonach man das Material aus dem Reaktor herausholt.

Das hergestellte Material stellt gemäss den Röntgenangaben einen supraleitenden Werkstoff folgender Zusammensetzung: $YBa_2Cu_3O_{6,95}$ mit einer orthorhombischen Struktur und einer Porosität von 50% dar.

Die Menge der supraleitenden Phase, die im Probekörper gleichmässig verteilt ist, beträgt nach den Angaben der Magnetpermeabilität 98%.

$T_{Beg.}$ = IOO K, $T_{Mit.}$ = 94 K, $\Delta T$ = I K, $T_{End.}$ = 95 K.
Die Korngrösse im Probekörper beträgt etwa 5 $\mu$m.

Beispiel I

Man bereitet ein exothermes Gemisch der Komponenten aus einem brennbaren Bestandteil, als solcher verwendet man Metallyttrium in einer Menge von 6,55 Masse%, und einem nichtbrennbaren Bestandteil: Yttriumoxid, einer Komponente, die ein Seltenerdmetall in einer Menge von 8,32 Masse% aufweist, Bariumperoxid, einer Komponente, die ein Metall der zweiten Gruppe in einer Menge von 49,94 Masse% aufweist, und Kupferoxid, einer Komponente, die ein Metall der ersten Gruppe in einer Menge von 35,I9 Masse% aufweist. Das zubereitete stöchiometrisch Komponentengemisch zerkleinert man unter Vermischen in einer Kugelmühle bis zum Erzieheln eines Dispersionsgrades von 0,05 mm, dann unterbringt man das Gemisch in einem Quarzreaktor, erhitzt man den Inhalt auf eine Temperatur von 600°C und initiiert man das Brennen des Gemisches in einem Oxydationsmedium (Sauerstoff mit Zugabe von 50 Vol.% Luft) unter Zuhilfenahme einer metallischen Spirale.

Das Brennen verbreitet sich im gesamten Volumen des Gemisches innerhalb von I0 bis I5 Sekunden. Die Abkühlung des Produktes auf Raumtemperatur erfolgt in demselben Oxydationsmedium. Die Dauer der Prozessführung, einschlisslich des Brennens und der Abkühlung, beträgt 30 Minuten. Der hergestellte Werkstoff weist folgenden Kenndaten der Supraleitfähigkeit auf:

$T_{Beg.}$ = I00 K, $T_{Mit.}$ = 94 K, $\Delta T_{(90-I0\%)}$ = I K. Der Werkstoff hat eine Porosität von 40%, er ist homogen im gesamten Volumen und weist eine Korngrösse von 5 µm auf, der Gehalt an Beimengungen (nichtumgesetzte Komponenten, Kohlenstoff und anderes mehr) in demselben beträgt $I0^{-2}$ Masse%. Die Menge der supraleitenden Phase beträgt gemäss den Ergebnissen der Messungen der Magnetpermeabilität 85%.

In der Tabelle I sind andere Beispiele der Durchführung des Verfahrens mit Angaben der Ausgangszusammensetzung des exothermen Gemisches, der Menge des brennbaren Bestandteils und der Bedingungen des Prozesses angeführt. In der Tabelle 2 sind die Eigenschaften des hergestellten Werkstoffs mit Angaben seiner supraleitenden Kenndaten angeführt.

Tabelle 1

| Lfd. Nr. | Ausgangskomponenten und ihr Gehalt im exothermen Gemisch (Masse%) | | | | | |
|---|---|---|---|---|---|---|
| | Seltenerdmetall oder seine Verbindung | | Metall der II. Gruppe oder seine Verbindung | | Metall der I. Gruppe oder seine Verbindung | |
| 1 | 2 | | 3 | | 4 | |
| 1. | Y 6,55 | $Y_2O_3$ 8,32 | $BaO_2$ 49,94 | | CuO 35,19 | |
| 2. | Y 14,2 | | BaO 48,35 | | CuO 37,63 | |
| 3. | Sc 7,51 | | $BaO_2$ 56,61 | | $Cu_2O$ 35,88 | |
| 4. | Y 7,26 | Sc 3,67 | BaO 50,09 | | CuO 38,98 | |
| 5. | 13,61 $YH_2$ | | 50,68 $BaO_2$ | | 35,71 CuO | |
| 6. | $YH_2$ 6,50 | $SmH_2$ 10,90 | $BaO_2$ 48,46 | | CuO 34,14 | |
| 7. | $Y_2O_3$ 19,66 | | $BaO_2$ 28,57 | $SrO_2$ 20,19 | Cu 32,18 | |
| 8. | $Gd_2O_3$ 19,6 | | $Ba(NO_3)_2$ 59,78 | | Cu 20,62 | |
| 9. | $Gd_2O_3$ 26,64 | | $BaCO_3$ 51,49 | | Cu 24,87 | |
| 10. | 24,58 $Eu_2O_3$ | | 47,31 $BaO_2$ | | 25,74 Cu | 2,37 $AgNO_3$ |

Fortsetzung der Tabelle 1

| 1 | 2 | | 3 | | 4 | |
|---|---|---|---|---|---|---|
| 11. | $HO_2(CO_3)_3$ | | Ba | | $Cu(NO_3)_2$ | |
| | 23,34 | | 25,15 | | 51,51 | |
| 12. | $HO_2O_3$ | | $BaH_2$ | | CuO | |
| | 26,75 | | 39,46 | | 33,79 | |
| 13. | $Er_2O_3$ | | $BaH_2$ | $CaH_2$ | CuO | |
| | 27,75 | | 36,39 | 1,23 | 34,63 | |
| 14. | $Y_2O_3$ | $Lu_2O_3$ | $BaO_2$ | | Cu | |
| | 8,24 | 14,52 | 49,42 | | 27,82 | |
| 15. | 38,83 | | 21,58 | 15,25 | 24,29 | |
| | $Yb_2(CrO_4)_3$ | | $BaO_2$ | $SrO_2$ | Cu | |
| 16. | $Lu(NO_3)_3$ | | $BaO_2$ | | Cu | |
| | 40,54 | | 38,04 | | 21,42 | |
| 17. | $Y_2O_3$ | $YF_3$ | $BaO_2$ | | Cu | |
| | 5,67 | 14,64 | 50,99 | | 28,70 | |
| 18. | $Y_2O_3$ | | $BaH_2$ | BaO | $CuF_2$ | CuO |
| | 17,11 | | 39,21 | 4,34 | 15,52 | 23,82 |

Fortsetzung der Tabelle 1

| Lfd. Nr. | Brennbarer Bestandteil, Masse% | Medium Vol.% | Mediumdruck, atm | Temperatur der Vorerhitzung, °C | Anmerkungen |
|---|---|---|---|---|---|
| 1 | 5 | 6 | 7 | 8 | 9 |
| 1. | 6,55 | Sauerstoff 50% Luft | 100 | 600 | |
| 2. | 14,02 | Sauerstoff | 50 | 200 | Vorformung des Ausgangsgemisches |
| 3. | 7,51 | Sauerstoff | 50 | 400 | -"- |
| 4. | 10,93 | Sauerstoff | 30 | 300 | |
| 5. | 13,61 | Sauerstoff | 15 | - | Anbrennen mit Laserstrahl |
| 6. | 17,40 | Sauerstoff | 10 | - | |
| 7. | 32,18 | Sauerstoff | 10 | - | Anbrennen mit elektrischem Lichtbogen |
| 8. | 20,62 | Sauerstoff | 1 | 100 | |
| 9. | 24,87 | Sauerstoff | 1 | - | Anbrennen mit Lichtstrahl |
| 10. | 25,74 | Sauerstoff | 1 | - | |
| 11. | 25,15 | Sauerstoff | 1 | - | |
| 12. | 39,46 | Sauerstoff +50% Luft | 1 | - | |
| 13. | 37,62 | Sauerstoff + 40% Argon | 75 | - | |
| 14. | 27,82 | Sauerstoff | 20 | - | Vorpressung des Gemisches |

Fortsetzung der Tabelle 1

| 1 | 5 | 6 | 7 | 8 | 9 |
|---|---|---|---|---|---|
| 15. | 24,29 | Sauerstoff | 10 | - | |
| 16. | 21,42 | Sauerstoff | 40 | 100 | |
| 17. | 28,70 | Sauerstoff +5% Fluor | 1 | - | |
| 18. | | Sauerstoff | 1 | - | |

Tabelle 2

| Lfd. Nr. | Phase | Charakteristik des Werkstoffes | | | Anmerkungen |
|---|---|---|---|---|---|
| | | $T_{Beg.}$ K | $T_{Mit.}$ K | Δ T (90-IO%) | |
| I. | $YBa_2Cu_3O_y$ | IOO | 94 | I | |
| 2. | $YBa_2Cu_3O_y$ | 98 | 94 | I | |
| 3. | $ScBa_2Cu_3O_y$ | 95 | 90 | 2 | |
| 4. | $Y_{0,5}Sc_{0,5}Ba_2Cu_3O_y$ | 96 | 93 | 2 | |
| 5. | $YBa_2Cu_3O_y$ | IOO | 94 | I | |
| 6. | $Y_{0,5}Sm_{0,5}Ba_2Cu_3O_y$ | 94 | 92 | 2 | |
| 7. | $YBaSrCu_3O_y$ | 94 | 90 | 2 | |
| 8. | $GdBa_2Cu_3O_y$ | 93 | 9I | 2 | |
| 9. | $GdBa_2Cu_3O_y$ | 93 | 90 | 2 | |
| IO. | $EuBa_2Cu_{2,9}Ag_{0,I}O_y$ | IOO | 94 | I | |
| II. | $HoBa_2Cu_3O_y$ | 96 | 92 | I | |
| I2. | $HoBa_2Cu_3O_y$ | 96 | 92 | I | |
| I3. | $ErBa_{I,8}Ca_{0,2}Cu_3O_y$ | 95 | 93 | 2 | |
| I4. | $Y_{0,5}Lu_{0,5}Ba_2Cu_3O_y$ | 96 | 93 | 2 | |
| I5. | $YbBa_2Cu_3O_y$ | 96 | 92 | 2 | |
| I6. | $LuBa_2Cu_3O_y$ | 92 | 90 | 2 | |
| I7. | $YBa_2Cu_3O_{y-2}F_2$ | IOO | 93 | I | |
| I8. | $YBa_2Cu_3O_{y-2}F_2$ | IOO | 94 | I | |

## Industrielle Anwendbarkeit

Supraleitende oxidische Werkstoffe finden Anwendung in der Elektronik, bei der Herstellung von supraleitenden Solenoiden und Uberzügen, Schnell-Rechenanlagen, bei der Produktion von Ausrüstungen für die Medizin und in der Tieftemperaturtechnik.

PATENTANSPRUCHE

I. Supraleitender oxidischer Werkstoff, der ein Seltenerdmetall des Periodensystems, ein Metall der ersten Gruppe und ein Metall der zweiten Gruppe des Periodensystems vorsieht, dadurch gekennzeichnet, dass man ein exothermes Gemisch zubereitet, die sich aus:

- einem nichtbrennbaren Bestandteil, als solcher verwendet man ein Gemisch;
- eines getrennt oder im Gemisch genommenen Oxids, Halogenids, Nitrats, Karbonats oder Oxalats eines Seltenerdmetalls des Periodensystems, gewählt aus der Reihe: Skandium, Yttrium, Lanthanoide;
- eines getrennt oder im Gemisch genommenen Oxids, Peroxids, Karbonats, Nitrats oder Halogenids eines Metalls der ersten Gruppe des Periodensystems;
- eines getrennt oder im Gemisch genommenen Oxids, Peroxids, Karbonats, Nitrats oder Halogenids eines Metalls der zweiten Gruppe des Periodensystems, und
- einem brennbaren Bestandteil zusammensetzen, als solcher verwendet man mindestens ein Metall, gewählt aus der Gruppe:
- das genannte Seltenerdmetall des Periodensystems;
- das Metall der ersten Gruppe des Periodensystems;
- das Metall der zweiten Gruppe des Periodensystems und/oder ein Hydrid mindestens eines Metalls, gewählt aus der Gruppe:
- das genannte Seltenerdmetall des Periodensystems;
- das Metall der zweiten Gruppe des Periodensystems, wobei man das gewonnene exotherme Gemisch in einem sauerstoffhaltigen Medium mit Uberschuss am Oxydationsmittel unterbringt, das lokale Anbrennen an beliebiger Stelle des zubereiteten exothermen Gemisches initiiert und den Uberschuss am Oxydationsmittel bis zum Abschluss der Reaktion unterhält.

2. Supraleitender oxidischer Werkstoff nach Anspruch I, dadurch gekennzeichnet, dass man das Ausgangsverhältnis des brennbaren Bestandteils zum nichtbrennbaren Bestandteil im exothermen Gemisch im stöchiometrischen Verhältnis der Ausgangskomponenten, berechnet auf die Herstellung eines Werkstoffs der Zusammensetzung im Atomverhältnis, nimmt:

Seltenerdmetall: Metall der zweiten Gruppe des Periodensystems: Metall der ersten Gruppe des Periodensystems: Oxydationsmittel = I : 2 : 3 : (6-8).

3. Supraleitender oxidischer Werkstoff nach Anspruch I, 2, dadurch gekennzeichnet, dass man das exotherme Gemisch der Komponenten bei folgendem Verhältnis in Masse% zubereitet:

brennbarer Bestandteil - von 6,55 bis 39,46
nichtbrennbarer Bestandteil - von 60,54 bis 93,45.

4. Supraleitender oxidischer Werkstoff nach Anspruch I, 3, dadurch gekennzeichnet, dass man als Metall der ersten Gruppe des Periodensystems Kupfer und Silber, genommen getrennt oder im Gemisch, verwendet.

5. Supraleitender oxidischer Werkstoff nach Anspruch I, 4, dadurch gekennzeichnet, dass man besonders vorzugsweise Kupfer verwendet.

6. Supraleitender oxidischer Werkstoff nach Anspruch I, dadurch gekennzeichnet, dass man als Metall der zweiten Gruppe des Periodensystems Kalzium, Strontium, Barium, genommen getrennt oder im Gemisch, verwendet.

7. Supraleitender oxidischer Werkstoff nach Anspruch 6, dadurch gekennzeichnet, dass man als Metall der zweiten Gruppe des Periodensystems Strontium und Barium, genommen getrennt oder im Gemisch, verwendet.

8. Supraleitender oxidischer Werkstoff nach Anspruch 7, dadurch gekennzeichnet, dass man vorzugsweise Barium verwendet.

9. Supraleitender oxidischer Werkstoff nach Anspruch I, dadurch gekennzeichnet, dass man als brennbaren Bestandteil mindestens ein der Seltenerdmetalle verwendet.

IO. Supraleitender oxidischer Werkstoff nach Anspruch I, dadurch gekennzeichnet, dass man als brennbaren Bestandteil ein Gemisch aus mindestens einem der Seltenerdmetalle mit einem Metall der ersten Gruppe des Periodensystems verwendet.

II. Supraleitender oxidischer Werkstoff nach Anspruch I, dadurch gekennzeichnet, dass man als brennbaren Bestandteil ein Gemisch aus mindestens einem der Seltenerdmetalle mit einem der Metalle der zweiten Gruppe des Periodensystems verwendet.

I2. Supraleitender oxidischer Werkstoff nach Anspruch I, dadurch gekennzeichnet, dass man als brennbaren Bestandteil ein Gemisch aus mindestens einem der Metalle der ersten Gruppe des Periodensystems und aus mindestens einem der Metalle der zweiten Gruppe des Periodensystems verwendet.

I3. Supraleitender oxidischer Werkstoff nach Anspruch I, dadurch gekennzeichnet, dass man als brennbaren Bestandteil Hydrid eines der Seltenerdmetalle des Periodensystems und Hydrid eines der Metalle der zweiten Gruppe des Periodensystems, genommen getrennt oder im Gemisch, verwendet.

I4. Supraleitender oxidischer Werkstoff nach Anspruch I3, dadurch gekennzeichnet, dass man Hydrid mindestens eines der Metalle der zweiten Gruppe des Periodensystems verwendet.

I5. Supraleitender oxidischer Werkstoff nach Anspruch I, dadurch gekennzeichnet, dass man als nichtbrennbaren Bestandteil Halogenid und Nitrat mindestens eines der Seltenerdmetalle des Periodensystems mit mindestens einem der Metalle der ersten und der zweiten Gruppe des Periodensystems verwendet.

I6. Supraleitender oxidischer Werkstoff nach Anspruch I5, dadurch gekennzeichnet, dass man als Halogenid, Fluorid, Bromid, Chlorid eines Seltenerdmetalls, eines Metalls der ersten Gruppe und des Metalls der zweiten Gruppe des Periodensystems verwendet.

I7. Supraleitender oxidischer Werkstoff nach Anspruch I6, dadurch gekennzeichnet, dass man als Halogenid besonders vorzugsweise Fluorid mindestens eines der Seltenerdmetalle des Periodensystems, des Metalls der ersten und der zweiten Gruppe des Periodensystems verwendet.

I8. Supraleitender oxidischer Werkstoff nach Anspruch

17, dadurch g e k e n n z e i c h n e t , dass man als Halogenid eines Metalls der zweiten Gruppe vorzugsweise Fluorid mindestens eines der Metalle der zweiten Gruppe des Periodensystems verwendet.

19. Supraleitender oxidischer Werkstoff nach Anspruch 1, dadurch g e k e n n z e i c h n e t , dass man als sauerstoffhaltiges Medium sauerstoff oder ein Gemisch aus Sauerstoff (20-95 Vol.%) mit einem Zusatz mindestens einer Komponente aus der Reihe Fluor, Argon, Menge von 5 bis 80 Vol.%, verwendet.

20. Supraleitender oxidischer Werkstoff nach Anspruch 19, dadurch g e k e n n z e i c h n e t , dass man ein Gemisch aus Sauerstoff mit Luft, Argon oder Fluor verwendet.

21. Supraleitender Werkstoff nach Anspruch 1, dadurch g e k e n n z e i c h n e t , dass man das Brennen des exothermen Gemisches vorzugsweise bei atmosphärischem Druck durchführt.

22. Supraleitender oxidischer Werkstoff nach Anspruch 1, dadurch g e k e n n z e i c h n e t , dass man das Brennen des exothermen Gemisches bei Druckwerten von 0,2 bis 15,0 MPa durchführt.

23. Supraleitender oxidischer Werkstoff nach Anspruch 1, dadurch g e k e n n z e i c h n e t , dass man die Komponenten des exothermen Gemisches vorher bis zu einer Teilchengrösse von 0,01 bis 0,1 mm zerkleinert.

24. Supraleitender oxidischer Werkstoff nach Ansprych 1, dadurch g e k e n n z e i c h n e t , dass man das exotherme Gemisch der Komponenten auf 100 bis 600°C vorerhitzt.

25. Supraleitender oxidischer Werkstoff nach Anspruch 1, dadurch g e k e n n z e i c h n e t , dass das lokale Anbrennen des exothermen Gemisches mit Hilfe einer elektrischen Spirale, eines elektrischen Lichtoogens, eines elektrischen Funkens, oder mit Licht- oder Laserstrahl, oder mit einem Elektromembündel, oder mittels Hochfrequenz--Induktionserhitzung erfolgt.

26. Supraleitender oxidischer Werkstoff nach Anspruch

25, dadurch g e k e n n z e i c h n e t , dass man das lokale Anbrennen des exothermen Gemisches vorzugsweise mit Hilfe der elektrischen Spirale durchführt.

27. Supraleitender oxidischer Werkstoff nach Anspruch 1, dadurch g e k e n n z e i c h n e t , dass man das exotherme Gemisch der Komponenten vorher in Form eines vorgegebenen Erzeugnisses formt.

28. Verfahren zur Herstellung eines supraleitenden oxidischen Werkstoffes, dadurch g e k e n n z e i c h n e t , dass man ein exothermes Gemisch der Komponenten zubereitet, die sich aus:

- einem nichtbrennbaren Bestandteil, als solcher verwendet man ein Gemisch;

- eines getrennt oder im Gemisch genommenen Oxids, Halogenids, Nitrats, Karbonats oder Oxalats eines Seltenerdmetalls des Periodensystems, gewählt aus der Reihe: Skandium, Yttrium, Lanthanoide;

- eines getrennt oder im Gemisch genommenen Oxids, Peroxids, Karbonats, Nitrats oder Halogenids eines Metalls der ersten Gruppe des Periodensystems;

- eines getrennt oder im Gemisch genommenen Oxids, Peroxids, Karbonats, Nitrats oder Halogenids eines Metalls der zweiten Gruppe des Periodensystems, und

- einem brennbaren Bestandteil zusammensetzen, als solcher verwendet man mindestens ein Metall, gewählt aus den Gruppe:

- das genannte Seltenerdmetall des Periodensystems;

- das Metall der ersten Gruppe des Periodensystems;

- das Metall der zweiten Gruppe des Periodensystems und/oder ein Hydrid mindestens eines Metalls, gewählt aus der Gruppe:

- das genannte Seltenerdmetall des Periodensystems;

- das Metall der zweiten Gruppe des Periodensystems, wobei man das exotherme Gemisch in einem sauerstoffhaltigen Medium mit Überschuss am Oxydationsmittel unterbinrgt, das lokale Anbrennen an beliebiger Stelle des zubereiteten exothermen Gemisches initiiert und den Überschuss am Oxydationsmittel bis zum Abschluss der Reaktion unterhält.

29. Verfahren nach Anspruch 28, dadurch g e k e n n - z e i c h n e t , dass man das Ausgangsverhältnis des brennbaren Bestandteils zum nichtbrennbaren Bestandteil im exothermen Gemisch im stöchiometrischen Verhältnis der Ausgangskomponenten, berechnet auf die Herstellung eines Werkstoffs der Zusammensetzung im Atomverhältnis, nimmt:

Seltenerdmetall des Periodensystems: Metall der zweiten Gruppe des Periodensystems: Metall der ersten Gruppe des Periodenaystems: Oxydationsmittel = 1 : 2 : 3 : (6-8).

30. Supraleitender oxidischer Werkstoff nach Anspruch 28-29, dadurch g e k e n n z e i c h n e t , dass ma man das exotherme Gemisch der Komponenten bei folgendem Verhältnis in Masse% zubereitet:

| | |
|---|---|
| brennbarer Bestandteil | - von 6,55 bis 39,46 |
| nichtbrennbarer Bestandteil | - von 60,54 bis 93,45. |

31. Verfahren nach Anspruch 29, dadurch g e k e n n - z e i c h n e t , dass man als Metall der ersten Gruppe des Periodensystems vorzugsweise Kupfer und Seilber, genommen getrennt oder im Gemisch verwendet.

32. Verfahren nach Anspruch 31, dadurch g e k e n n - z e i c h n e t , dass man als Metall der ersten Gruppe des Periodensystems besonders vorzugsweise Kupfer verwendet.

33. Verfahren nach Anspruch 32, dadurch g e k e n n - z e i c h n e t , dass man als Metall der zweiten Gruppe des Periodensystems vorzugsweise Kalzium, Strontium, Barium, genommen getrennt oder im Gemisch, verwendet.

34. Verfahren nach Anspruch 33, dadurch g e k e n n - z e i c h n e t , dass man als Metall der zweiten Gruppe des Periodensystems vorzugsweise Strontium und Barium genommen getrennt oder im Gemisch, verwendet.

35. Verfahren nach Anspruch 34, dadurch g e k e n n - z e i c h n e t , dass man als Metall der zweiten Gruppe des Periodensystems besonders vorzugsweise Barium verwendet.

36. Verfahren nach Anspruch 28-30, dadurch g e - k e n n z e i c h n e t , dass man als brennbaren Bestandteil mindestens ein der Seltenerdmetalle verwendet.

37. Verfahren nach Snspruch 28, 30, dadurch g e - k e n n z e i c h n e t , dass man als brennbaren Bestandteil ein Gemisch aus mindestens einem der Seltenerdmetalle mit mindestens einem Metall der ersten Gruppe des Periodensystems verwendet.

38. Verfahren nach Anspruch 28, dadurch g e - k e n n z e i c h n e t , dass man als brennbaren Bestandteil ein Gemisch aus mindestens einem der Seltenerdmetalle mit mindestens einem der Metalle der zweiten Gruppe des Periodensystems verwendet.

39. Verfahren nach Anspruch 28, dadurch g e k e n n - z e i c h n e t , dass man als brennbaren Bestandteil ein Gemisch aus mindestens einem der Metalle der ersten Gruppe des Periodensystems und aus mindestens einem der Metalle der zweiten Gruppe des Periodensystems, verwendet.

40. Verfahren nach Anspruch 30, dadurch g e k e n n - z e i c h n e t , dass man als brennbaren Bestandteil Hydrid eines Seltenmetalls des Periodensystems und Hydrid eines Metalls der zweiten Gruppe des Periodensystems, genommen getrennt oder im Gemisch, verwendet.

41. Verfahren nach Anspruch 40, dadurch g e k e n n - z e i c h n e t , dass man Hydrid mindestens eines der Metalle der zweiten Gruppe des Periodensystems verwendet.

42. Verfahren nach Anspruch 28, 30, dadurch g e - k e n n z e i c h n e t , dass man als nichtbrennbaren Bestandteil Halogenid und Nitrat mindestens eines der Seltenerdmetalle des Periodensystems einem der Metalle der ersten und der zweiten Gruppe des Periodensystems verwendet.

43. Verfahren nach Anspruch 42, dadurch g e k e n n - z e i c h n e t , dass man als Halogenid Fluorid, Bromid, Chlorid eines Seltenerdmetalls, Metall der ersten und der zweiten Gruppe des Periodensystems verwendet.

44. Verfahren nach Anspruch 43, dadurch g e k e n n - z e i c h n e t , dass man als Halogenid eines Metalls besonders vorzugsweise Fluorid mindestens eines der Seltenerdmetalle, der Metalle der ersten und der zweiten Gruppe des Periodensystems verwendet.

45. Verfahren nach Anspruch 28, 30, dadurch g e k e n n z e i c h n e t , dass man als ein sauerstoffhaltiges Medium Sauerstoff oder ein Gemisch aus Sauerstoff (von 20 bis 95 Vol.%) ,mit einem Zusatz mindestens einer Komponente aus der Reihe Argon, Stickstoff, Luft, Fluor, verwendet, die in einer Menge von 5 bis 80 Vol.% genommen werden.

46. Verfahren nach Anspruch 45, dadurch g e k e n n z e i c h n e t , dass man als sauerstoffhaltiges Medium vorzugsweise ein Gemisch aus Sauerstoff mit Luft, Argon oder Fluor verwendet.

47. Verfahren nach Anspruch 28, dadurch g e k e n n z e i c h n e t , dass man das Brennen des exothermen Gemisches vorzugsweise bei atmosphärischem Druck durchführt.

48. Verfahren nach Anspruch 28, dadurch g e k e n n z e i c h n e t , dass man das Brennen des exothermen Gemisches bei Druckwerten von 0,2 bis 15,0 MPa durchführt.

49. Verfahren nach Anspruch 28, dadurch g e k e n n z e i c h n e t , dass man die Ausgangskomponenten des exothermen Gemisches vorher bis zu einer Teilchegrösse von 0,1 bis 0,1 mm zerkleinert.

50. Verfahren nach Anspruch 28, dadurch g e k e n n z e i c h n e t , dass man das exotherme Gemisch der Komponenten vor dem Initiieren des Brennens auf 100 bis 600°C erhitzt.

51. Verfahren nach Anspruch 28, dadurch g e k e n n z e i c h n e t , dass das lokale Anbrennen des exothermen Gemisches mit Hilfe einer elektrischen Spirale, eines elektrischen Lichtbogens, eines elektrischen Funkens, oder mit Licht- oder Laserstrahl, oder mit einem Elektronenbündel oder mittels Hochfrequenz-Induktionserhitzung erfolgt.

52. Verfahren nach Anspruch 28, dadurch g e k e n -

z e i c h n e t , dass man das lokale Anbrennen des exothermen Gemisches vorzugsweise mit Hilfe der elektrischen Spirale durchführt.

53. Verfahren nach Anspruch 28, dadurch g e - k e n n z e i c h n e t , dass man das exotherme Gemisch der Komponenten vorher in Form eines vorgegebenen Erzeugnisses formt.

# INTERNATIONAL SEARCH REPORT

International Application No PCT/SU 88/00113

**I. CLASSIFICATION OF SUBJECT MATTER** (if several classification symbols apply, indicate all) [6]

According to International Patent Classification (IPC) or to both National Classification and IPC

$IPC^4$ C 04 B 35/50, H 01 B 12/00

**II. FIELDS SEARCHED**

Minimum Documentation Searched [7]

| Classification System | Classification Symbols |
|---|---|
| $IPC^4$ | C 01 F 17/00, C 04 B 35/50, H 01 B 12/00, H 01 L 39/12 |

Documentation Searched other than Minimum Documentation to the Extent that such Documents are Included in the Fields Searched [8]

CS

**III. DOCUMENTS CONSIDERED TO BE RELEVANT** [9]

| Category * | Citation of Document, [11] with indication, where appropriate, of the relevant passages [12] | Relevant to Claim No. [13] |
|---|---|---|
| Y | CZECHOSLOVAK JOURNAL OF PHYSICS,vol.B 37, No. 5, 1987, (ACADEMIA, PRAGUE), J. Sebek et al. "Magnetic hysteresis phenomena in hich $T_c$ superconductors", see pages 660-664 | 2,3,11, I-(in respect of the compound) |
| Y | JOURNAL OF THE AMERICAN CHEMICAL SOCIETY,vol. 109,No.9, April 1987, E.M. Engler et al. "Superconductivity above Liquid Nitrogen Temperature: Preparation and Properties of a Family of Perovskite-Based Superconductors", see pages 2848-2849 | 2,3,9-11 |
| A | - " - | 1-(in respect of the method) 13-53 |
| Y | JAPANESE JOURNAL OF APPLIED PHYSICS, part I, Regular Papers & Short Notes, vol. 26, No. 3, March 1987, Yoshitami SAITO et al. "Composition Dependence of the High Temperature Superconductivity in (Ba, Sr)-La-(Hg, Ag)-Cu-O System with $K_2NiF_4$-Type Structure",see page L223-L224 | 4,5,10-12 |
| Y | PHYSICAL REVIEW B CONDENSED MATTER, vol. 35, No. 10, April 1987, D.K. Finnemore et al. "Magnetization of superconducting lanthanum copper oxides" see pages | 6-8 |

./.

* Special categories of cited documents: [10]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art.

"&" document member of the same patent family

**IV. CERTIFICATION**

| Date of the Actual Completion of the International Search | Date of Mailing of this International Search Report |
|---|---|
| 11 August 1988 (11.08.88) | 1 September 1988 (01.09.88) |
| International Searching Authority | Signature of Authorized Officer |
| ISA/SU | |

International Application No. PCT/SU 88/00113

**FURTHER INFORMATION CONTINUED FROM THE SECOND SHEET**

5319-5322

---

**V. ☐ OBSERVATIONS WHERE CERTAIN CLAIMS WERE FOUND UNSEARCHABLE [1]**

This international search report has not been established in respect of certain claims under Article 17(2) (a) for the following reasons:

1. ☐ Claim numbers .........., because they relate to subject matter not required to be searched by this Authority, namely:

2. ☐ Claim numbers .........., because they relate to parts of the international application that do not comply with the prescribed requirements to such an extent that no meaningful international search can be carried out, specifically:

3. ☐ Claim numbers .........., because they are dependent claims and are not drafted in accordance with the second and third sentences of PCT Rule 6.4(a).

**VI. ☐ OBSERVATIONS WHERE UNITY OF INVENTION IS LACKING [2]**

This International Searching Authority found multiple inventions in this international application as follows:

1. ☐ As all required additional search fees were timely paid by the applicant, this international search report covers all searchable claims of the international application.
2. ☐ As only some of the required additional search fees were timely paid by the applicant, this international search report covers only those claims of the international application for which fees were paid, specifically claims:
3. ☐ No required additional search fees were timely paid by the applicant. Consequently, this international search report is restricted to the invention first mentioned in the claims; it is covered by claim numbers:
4. ☐ As all searchable claims could be searched without effort justifying an additional fee, the International Searching Authority did not invite payment of any additional fee.

Remark on Protest

☐ The additional search fees were accompanied by applicant's protest.

☐ No protest accompanied the payment of additional search fees.